Europäisches Patentamt

European Patent Office

Office européen des brevets

(19)

(11) Veröffentlichungsnummer: 0 463 589 A2

# EUROPÄISCHE PATENTANMELDUNG

(12)

(21) Anmeldenummer: 91110331.5

(22) Anmeldetag: 22.06.91

(51) Int. Cl.5: H01L 23/495, H01L 25/07

(30) Priorität: 29.06.90 DE 4020849

(43) Veröffentlichungstag der Anmeldung:
02.01.92 Patentblatt 92/01

(84) Benannte Vertragsstaaten:
AT DE FR GB IT

(71) Anmelder: ABB-IXYS Semiconductor GmbH
Edisonstrasse 15
W-6840 Lampertheim(DE)

(72) Erfinder: Hierholzer, Martin
Lindenstrasse 34
W-6944 Hemsbach(DE)
Erfinder: Neidig, Arno, Dr.
Brühler Weg 22
W-5831 Plankstadt(DE)
Erfinder: Bayerer, Reinhold, Dr.
Forststrasse 27a
W-6101 Reichelsheim(DE)

(74) Vertreter: Rupprecht, Klaus, Dipl.-Ing. et al
c/o ABB Patent GmbH, Patentabteilung,
Postfach 10 03 51
W-6800 Mannheim 1(DE)

(54) Leistungshalbleitermodul mit integrierter Ansteuerungs- und Fehlerschutzplatine.

(57) Bekannte Leistungshalbleitermodule mit integrierter Platine für Ansteuer- und Fehlerschutzeinrichtungen enthalten die Platine in paralleler Anordnung zu einem Bodensubstrat des Moduls. Mit der Erfindung wird eine gegenüber der Bodenplatte (3) senkrechte Anordnung der Platine (6), vorzugsweise als Teil einer Außenwand des Moduls vorgeschlagen, wodurch eine einfachere Herstellbarkeit und eine verbesserte Kühlung gegeben sind.

Fig 8

EP 0 463 589 A2

Die Erfindung bezieht sich auf ein Leistungshalbleitermodul nach dem Oberbegriff des Anspruchs 1. Derartige Leistungshalbleitermodule mit integrierten Ansteuerungs- und Fehlerschutzeinrichtungen sind unter der Bezeichnung "SMART-Power-Module" bekannt geworden. Solche aus verschiedenen Firmendruckschriften bekannte Module sind insofern gleichartig aufgebaut, als innerhalb eines Gehäuses parallel zu einem Bodensubstrat mit Leistungshalbleiterbauelementen in einer zweiten Ebene eine Platine mit Ansteuerungs- und Schutzeinrichtungen angeordnet ist.

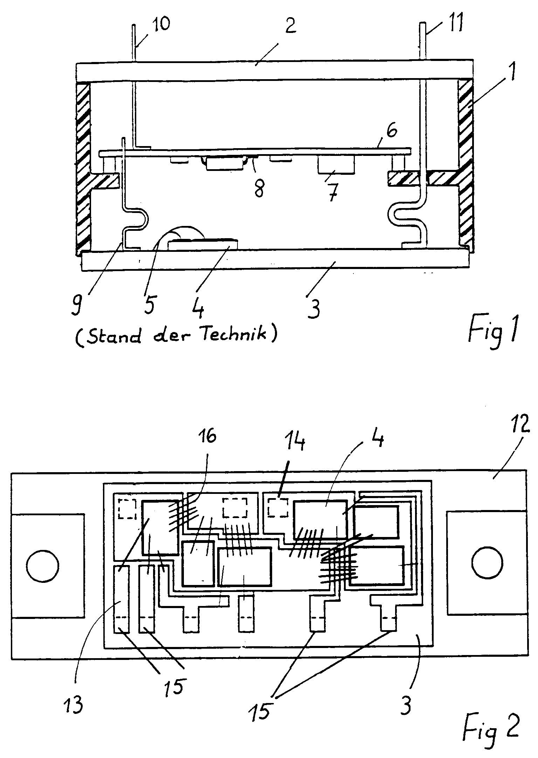

Ein typisches Leistungshalbleitermodul nach dem Stand der Technik, also ein Modul mit einer Ansteuerungsplatine in einer zweiten Ebene zeigt die Figur 1. Dieses Modul ist aus PCIM Europe, July 1989, Seite 131 bis 133 bekannt.

Das Leistungshalbleitermodul weist ein Gehäuse auf, welches aus einem Rahmen 1, einem Deckel 2 und einem Bodensubstrat 3 besteht. Das Bodensubstrat 3 trägt auf der dem Gehäuseinneren zugewandten Oberseite wenigstens ein Leistungshalbleiterbauelement 4 und eine Verdrahtung 5. In einer zweiten Ebene parallel zum Bodensubstrat 3 ist eine Platine 6 mit Bauelementen 7 und Leitungen 8 für Schaltungen mit Ansteuer- und Fehlerschutzfunktionen angeordnet. Zwischen dem Bodensubstrat 3 und der Platine 6 sind Verbindungsleitungen 9 vorhanden. Außerdem sind auf der Platine 6 Steueranschlüsse 10 angeordnet und auf dem Bodensubstrat 3 Leistungsanschlüsse 11, welche durch den Deckel 2 nach oben herausgeführt sind.

Die bekannte Bauweise gemäß Figur 1 hat einige Nachteile. Insbesondere ist die Fertigung aufwendig, weil mehrere Prozeßschritte zur Herstellung der erforderlichen elektrischen Verbindungen notwendig sind. Zur Fertigstellung des Moduls wird zunächst die vorgefertigte Bodenplatte 3 in den Rahmen 1 des Gehäuses eingesetzt, es werden die Anschlüsse 9 und 11 angelötet und es wird mit einem Silikongel vergossen. Danach wird die vorgefertigte Platine 6 in das Gehäuse eingesetzt, wobei die Verbindungsleitungen 9 durch die Platine 6 geführt und fixiert und anschließend verlötet werden. Die Verbindungsleitungen 9 müssen somit in zwei Schritten gelötet oder geschweißt werden, wodurch eine erhöhte Fehlerwahrscheinlichkeit gegeben ist. Eine Automatisierung der Fertigung ist erschwert, da die Verbindungsleitungen 9 eine geringe mechanische Stabilität aufweisen. Werden Platinen 6 mit vormontierten Verbindungsleitungen 9 benutzt, so ist eine Verbindung mit dem Bodensubstrat 3 wegen fehlender Zugänglichkeit ebenfalls schwierig. Außerdem ist die bekannte Bauweise hinsichtlich der Wärmeabfuhr ungünstig, wodurch es unter dem Deckel 2 zu einem Wärmestau kommt. Von den Bauelementen auf der Platine 6 kann dann keine Wärme abgeführt werden.

Davon ausgehend liegt der Erfindung die Aufgabe zugrunde, ein Leistungshalbleitermodul mit integrierter Ansteuerungs- und Fehlerschutzelektronik anzugeben, welches die Nachteile bekannter Module vermeidet.

Diese Aufgabe wird durch ein Leistungshalbleitermodul mit einem Gehäuse aus elektrisch isolierendem Material gelöst, in welches als Bodenplatte ein wenigstens auf einer Hauptfläche mit Metall beschichtetes Keramiksubstrat eingesetzt ist, auf dessen dem Modulinneren zugewandten Oberseite wenigstens ein Leistungshalbleiterbauelement angeordnet ist, und mit einer Ansteuerungs- und Fehlerschutzplatine, wobei die Ansteuerungs- und Fehlerschutzplatine im wesentlichen senkrecht zum Bodensubstrat im Leistungshalbleitermodul angeordnet ist.

Ein solches Leistungshalbleitermodul kann rationell unter Verwendung von Automaten hergestellt werden und erfordert nur eine geringe Zahl von Lötverbindungen. Die mit der Erfindung vorgeschlagene vertikale, also im Winkel von etwa 90° gegenüber dem Bodensubstrat angeordnete Platine mit Ansteuerungs- und Fehlerschutzeinrichtungen ermöglicht eine Reihe von vorteilhaften Ausgestaltungen, welche nachstehend im Rahmen einer Beschreibung von Ausführungsbeispielen anhand der Zeichnung erläutert sind.

Es zeigt:

| Fig. 1 | ein Leistungshalbleitermodul nach dem Stand der Technik, |
|---|---|
| Fig. 2 | Blick auf das Bodensubstrat eines erfindungsgemäßen Moduls, welches den Leistungsteil des Moduls bildet, |
| Fig. 3 und 4 | Anordnung der Ansteuerungs- und Fehlerschutzplatine senkrecht zum Bodensubstrat, |
| Fig. 5 bis 7 | Anordnung der Platine innerhalb des Moduls, |
| Fig. 8 und 9 | Anordnung der Platine als Außenwand des Modulgehäuses. |

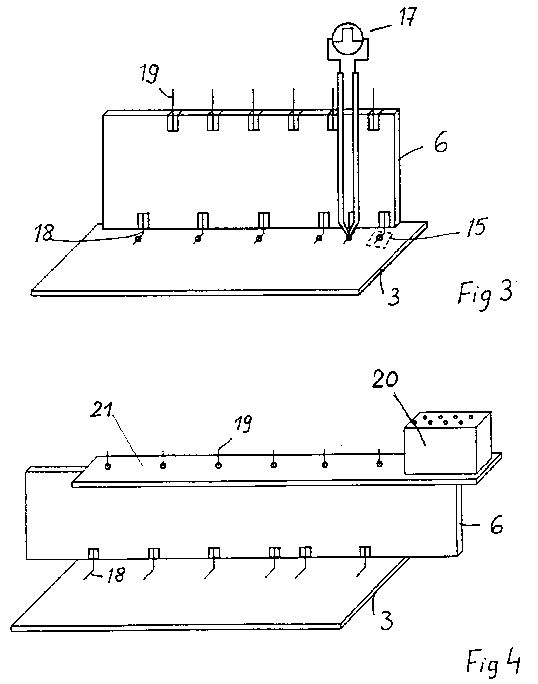

Figur 2 zeigt einen Teil eines erfindungsgemäßen Leistungshalbleitermoduls nach einem Fertigungsschritt, in welchem in einem Kunststoffgehäuse 12 in der Bodenebene ein Bodensubstrat 3 eingesetzt ist. In der dargestellten Draufsicht auf die Oberseite des Bodensubstats 3 sind aus Kupferfolien hergestellte und nach einem Direkt-Verbindungsverfahren mit dem keramischen Substrat 3 verbundene Leiterbahnen 13 zu erkennen. Auf den Leiterbahnen 13 sind Leistungshalbleiterbauelemente 4, z.B. IGBT oder Thyristoren montiert. Mit gestrichelten Linien auf den Leiterbahnnen 13 angedeutete Anschlußfelder 14 sind für später zu montierende Leistungsanschlüsse vorgesehen. Außerdem sind Lötflächen 15 für eine anschließende Verbindung des Bodensubstrats 3 mit einer Ansteuerungs- und Fehlerschutzplatine vorhanden. Verbindungen zwischen den Leistungshalbleiterbauelementen sind mit Bonddrähten 16 hergestellt, soweit Verbindungen über Leiterbahnen 13 nicht möglich sind.

Figur 3 zeigt einen weiteren Fertigungsschritt, in welchem eine senkrecht zum Bodensubstrat 3 angeordnete Platine 6 mit Hilfe eines Lötautomaten 17 montiert wird. Das Kunststoffgehäuse 12 ist in der Figur 3 nicht dargestellt.

Die Platine 6 kann z.B. eine Kunststoffplatine oder ein Multilayer-Substrat sein oder als Keramikhybrid ausgeführt sein, je nach den Anforderungen an die Temperaturbeständigkeit. Die Platine 6 trägt die erforderlichen Verbindungsleitungen und Bauelemente zur Realisierung von Ansteuerungs- und Fehlerschutzfunktionen, z.B. auch einer Kurzschlußüberwachung oder einer Temperaturüberwachung. Diese Verbindungsleitungen und Bauelemente auf der Platine 6 sind in Figur 3 nicht dargestellt. Gezeigt sind jedoch rechtwinklig abgebogene erste Anschlußbeine 18 der als Keramikhybrid ausgeführten Platine 6, welche mit Hilfe des Lötautomaten 17 jeweils im Bereich der Anschlußflächen 15 (siehe auch Figur 2) des Bodensubstrats 3 mit dessen Leiterbahnen 13 verlötet werden. Im Vergleich zum Stand der Technik, bei welchem die Verbindungsleitungen 9 an beiden Enden verlötet werden müssen, sind bei der erfindungsgemäßen Lösung nur halb soviele Lötstellen erforderlich, da die Anschlußbeine 18 als Kamm bereits Bestandteil der Platine 6 sind, und daher mit dieser mitgeliefert werden. Durch die Verwendung dieses Anschlußkamms entfallen im Gegensatz zum Stand der Technik Lötverbindungen auf der Platine, wodurch eine thermische Belastung wärmeempfindlicher Bauelemente entfällt. Außerdem werden im Gegensatz zum Stand der Technik keine Löcher in der Platine benötigt, was den Einsatz einer Hybridkeramik wesentlich wirtschaftlicher macht. Ein weiterer Vorteil ergibt sich daraus, daß das Leistungssubstrat 3 beim Einkleben in den Rahmen 1 bzw. das Gehäuse 12 noch ohne Verbindungsleitungen ist, was die Handhabung wesentlich erleichtert. Die vertikale Anordnung der Platine 6 erleichtert die Anwendung von Lötautomaten 17, d.h. eines Widerstandslötgerätes sehr, da ein Zugang von oben gegeben ist. Anstelle von Löten sind auch andere Verbindungstechniken, wie z.B. Outer-Lead-Bonden möglich.

Die Platine 6 weist weiterhin zweite Anschlußbeine 19 auf, welche an der oberen Kante der Platine 6 überstehen und für eine Leitungsverbindung zu einem Steueranschlußstecker 20 (siehe Figur 4) vorgesehen sind.

Figur 4 zeigt einen weiteren Fertigungsschritt, wobei in der Darstellung das in Figur 2 gezeigte Kunststoffgehäuse 12 weggelassen wurde. Figur 4 zeigt neben dem Bodensubstrat 3 mit senkrecht darauf montierter Platine 6 eine Leiterplatte 21, welche elektrische Verbindungen zwischen den zweiten Anschlußbeinen 19 und einem Steueranschlußstecker 20 herstellt. Die Leiterplatte 21 ist also eine elektrisch isolierende Platte mit mehreren Leiterbahnen. Ihre nicht gezeigten Leiterbahnen werden einerseits mit den zweiten Anschlußbeinen 19, andererseits mit Anschlußstiften des Steckers 20 verlötet. Anstelle der in Figur 4 dargestellten Anordnung zur Herstellung eines Steueranschlusses können selbstverständlich auch andere Techniken, z.B. Herausführen der zweiten Anschlußbeine 19 als äußerer Steueranschluß oder Herausführen eines Kabelstranges aus dem Modul oder Anschluß des Steckers 20 über eine flexible Leitung gewählt werden. Außerdem kann auch ein für Oberflächenmontagetechnik geeigneter Stecker 20 ohne Zwischenschaltung der Leiterplatte 21 direkt mit der Platine 6 verlötet werden.

Zur Fertigstellung des Moduls wird in das Modulinnere eine Vergußmasse eingefüllt und ein nicht dargestellter Gehäusedeckel aufgesetzt. Vom Stecker 20 ausgehende Zug- und Druckkräfte werden durch entsprechende konstruktive Maßnahmen formschlüssig von Gehäuse und Deckel aufgenommen. Der Steueranschlußstecker 20 ist im Ausführungsbeispiel achtpolig ausgeführt.

Das Modul kann auf unterschiedliche Weise vergossen werden. Gemäß einer ersten Variante kann durch eine senkrecht zum Bodensubstrat 3 angeordnete Zwischenwand der Innenraum des Moduls unterteilt werden in einen ersten Teil, welcher die Platine 6 enthält, und einen zweiten Teil, in welchem Leistungsanschlüsse 11 (siehe Figur 1) angeordnet sind. Die Zwischenwand hat dabei einen Abstand von einigen Millimetern zum Leistungssubstrat. Der untere Teil des Moduls wird in diesem Fall vollständig mit Weichvergußmasse, z.B. einem Silikongel, ausgegossen, während der zweite Teil anschließend mit einer Hartvergußmasse ausgefüllt wird, welche Leistungsanschlüssen 11 einen Halt verleiht.

Gemäß einer zweiten Variante wird der gesamte Innenraum des Moduls mit einer weichen Vergußmasse ausgefüllt und die Leistungsanschlüsse 11 werden mit anderen Mitteln, wie z.B. Kleben, befestigt.

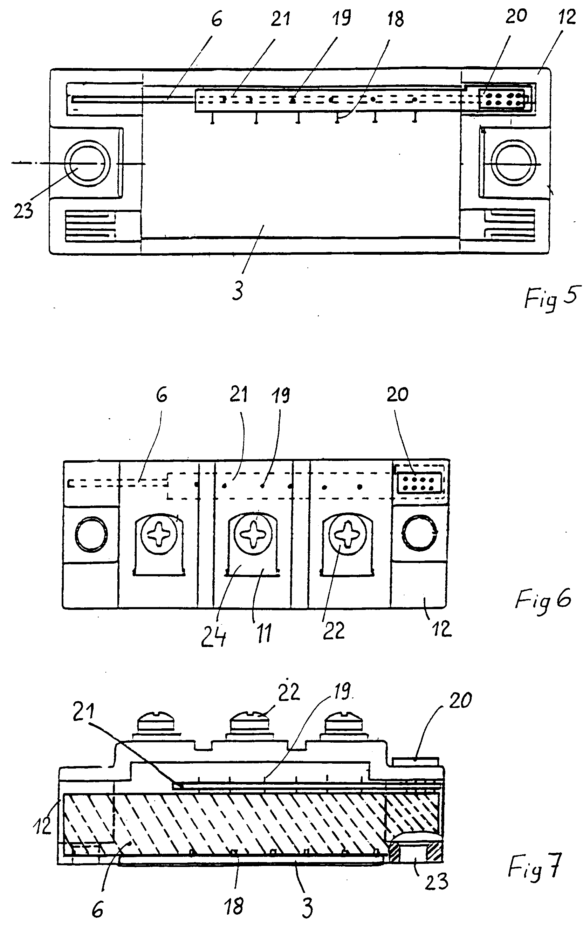

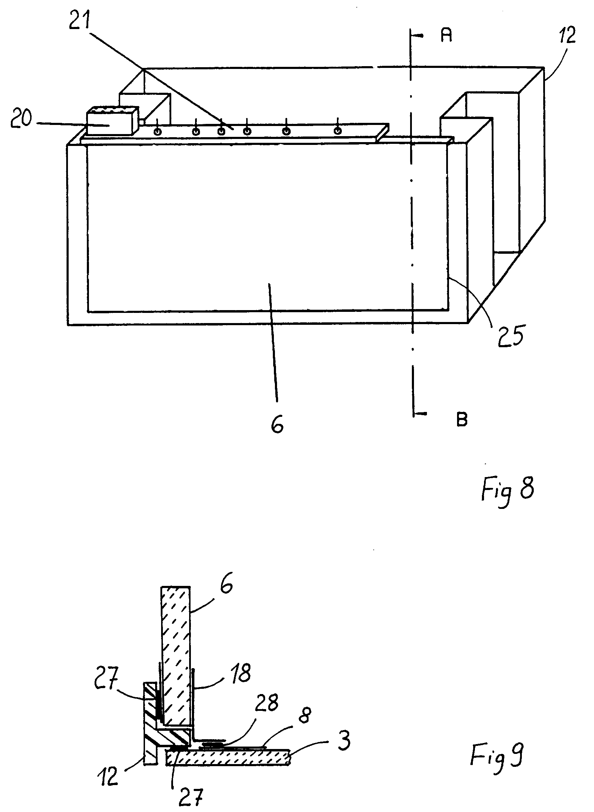

Die Figuren 5 bis 7 zeigen eine erste Variante für die senkrechte Anordnung der Platine 6 im Kunststoffgehäuse 12 eines Leistungshalbleitermoduls. Dabei ist die Platine 6 parallel zu einer Außenwand des Kunststoffgehäuses 12 angeordnet. Figur 5 zeigt einen Blick von oben in ein Modul, dessen Gehäusedeckel abgenommen ist, wobei eine Anordnung, wie in Figur 4 dargestellt, innerhalb des Gehäuses 12 vorhanden ist. Figur 6 zeigt das gleiche Modul von oben bei geschlossenem Deckel, wobei als Hauptanschlüsse 24 umgebogene Leistungsanschlüsse 11 und Anschlußschrauben 22 zu erkennen sind. Mit 23 ist jeweils ein Loch in einem Flanschbereich des Kunststoffgehäuses 12 bezeichnet, das zur Befestigung mittels Schrauben auf einem Kühlkörper vorgesehen ist. Figur 7 zeigt eine Seitenansicht des aufgeschnittenen Moduls gemäß Figur 5 und 6.

Die Figuren 8 und 9 zeigen eine zweite Variante zur Anordnung der Platine 6, bei welcher eine besonders gute Wärmeabgabe von der Platine 6 an die Umgebungsluft gegeben ist. Dabei ist ein Gehäuse ohne Deckel dargestellt. Wie Figur 8 zeigt, ist die Platine 6 in einer Ausnehmung 25 in einer Seitenwand eingesetzt, ähnlich wie das Bodensubstrat 3 (siehe Figur 1 oder 7) in der Bodenebene. Die Platine ist einseitig, d.h. nur auf der dem Modulinneren zugewandten Seite, bestückt.

Figur 9 zeigt Einzelheiten anhand eines Schnittes durch eine in Figur 8 eingetragene Ebene A-B. Es ist zu erkennen, daß in diesem Fall die Platine 6 nicht direkt auf dem Bodensubstrat 3 aufliegt, sondern auf einem Absatz 26 im Kunststoffgehäuse 12 und die ersten Anschlußbeine 18 entsprechend angepaßt sind. Sowohl das Bodensubstrat 3 als auch die Platine 6 sind mit Klebstoff 27 in das Gehäuse 12 eingeklebt. Die Anschlußbeine 18 sind mit Lot 28 mit Leitungen 8 verbunden, welche als strukturierte Metallfolien auf dem Bodensubstrat 3 ausgeführt sind.

Anstelle des in Figur 7 und 9 dargestellten keramischen Bodensubstrats 3 könnte auch eine Metallbodenplatte verwendet werden.

Bezugszeichenliste

| 1 | Rahmen |
| 2 | Deckel |
| 3 | Bodensubstrat |
| 4 | Leistungshalbleiterbauelement |
| 5 | Verdrahtung |
| 6 | Ansteuerungs- und Fehlerschutzplatine |
| 7 | Bauelemente |
| 8 | Leitungen |
| 9 | Verbindungsleitung |
| 10 | Steueranschlüsse |
| 11 | Leistungsanschlüsse |
| 12 | Kunststoffgehäuse |
| 13 | Leiterbahnen |
| 14 | Anschlußfeld |
| 15 | Lötfläche |
| 16 | Bonddraht |
| 17 | Lötautomat |
| 18 | erste Anschlußbeine |
| 19 | zweite Anschlußbeine |
| 20 | Steueranschlußstecker |
| 21 | Leiterplatte |
| 22 | Anschlußschraube |
| 23 | Loch für Befestigungsschrauben |
| 24 | Hauptanschluß |
| 25 | Ausnehmung |
| 26 | Absatz |
| 27 | Klebstoff |
| 28 | Lot |

**Patentansprüche**

1. Leistungshalbleitermodul mit einem Gehäuse aus elektrisch isolierendem Material, in welches als Bodenplatte ein wenigstens auf einer Hauptfläche mit Metall beschichtetes Keramiksubstrat eingesetzt ist, auf dessen dem Modulinneren zugewandten Oberseite wenigstens ein Leistungshalbleiterbauelement angeordnet ist, und mit einer Ansteuerungs- und Fehlerschutzplatine, dadurch gekennzeichnet, daß die Ansteuerungs- und Fehlerschutzplatine (6) im wesentlichen senkrecht zum Bodensubstrat (3) im Leistungshalbleitermodul angeordnet ist.

2. Leistungshalbleitermodul nach Anspruch 1, dadurch gekennzeichnet, daß die Platine (6) auf dem Bodensubstrat (3) stehend parallel zu einer Seitenwand des Gehäuses (12) innerhalb des Moduls angeordnet ist.

3. Leistungshalbleitermodul nach Anspruch 1, dadurch gekennzeichnet, daß die Platine (6) eine Außenwand des Gehäuses (12) ist oder in eine Ausnehmung (25) einer Außenwand des Gehäuses (12) eingesetzt ist.

4. Leistungshalbleitermodul nach einem der vorstehenden Ansprüche, daduch gekennzeichnet, daß die Platine (6) auf einem Keramikhybrid, einer Kunststoffplatine oder einem Mehrschicht-Substrat basiert.

5. Leistungshalbleitermodul nach einem der vorstehenden Ansprüche, dadurch gekennzeichnet, daß das Gehäuse (12) aus einem Kunststoff besteht.

6. Leistungshalbleitermodul nach einem der vorstehenden Ansprüche, dadurch gekennzeichnet, daß das Gehäuse (12) rahmenförmig oder haubenförmig mit den erforderlichen Öffnungen zur Durchführung von Anschlüssen (10,11) oder zum Einfüllen von Vergußmasse ausgeführt ist und gegebenenfalls Zwischenwände aufweist.

7. Leistungshalbleitermodul nach einem der vorstehenden Ansprüche, dadurch gekennzeichnet, daß die Platine (6) wenigstens in einem Randbereich Anschlußbeine (18,19) aufweist zur Verbindung mit Leiterbahnen (13) auf dem Bodensubstrat (3) oder auf einer Leiterplatte (21) für einen Steueranschluß.

(Stand der Technik)

Fig 1

Fig 2

Fig 3

Fig 4

Fig 5

Fig 6

Fig 7

Fig 8

Fig 9